# EUROPEAN PATENT APPLICATION

(11) **EP 4 266 351 A1**
(43) Date of publication of application: **25.10.2023**
(21) Application number: 23167095.1
(22) Date of filing: 06.04.2023
(51) Int. Cl.: H01L 21/285, H01L 21/768, H01L 23/485

(54) **SEMICONDUCTOR DEVICE**

(30) Priority: 14.04.2022 KR 20220046364
(71) Applicant: Samsung Electronics Co., Ltd., Suwon-si, Gyeonggi-do 16677 (KR)
(72) Inventor: MIN, Sunki, 16677 Suwon-si (KR)
(74) Representative: Marks & Clerk LLP

(57) **Abstract**

A semiconductor device includes: an active pattern extending in a first direction, parallel to an upper surface of a substrate, on the substrate; a gate structure extending in a second direction, intersecting the first direction, on the active pattern; a source/drain region disposed in a region, adjacent to the gate structure, on the active pattern; an interlayer insulating layer covering the gate structure and the source/drain region; and a contact structure penetrating through the interlayer insulating layer and contacting the source/drain region. The contact structure may include a contact plug, an insulating liner surrounding a sidewall of the contact plug, and a conductive barrier layer disposed between the insulating liner and the contact plug and on a bottom surface of the contact plug. The conductive barrier layer may have a barrier extension portion extending downwardly from a lower end of the insulating liner.

## Description

### BACKGROUND

The present disclosure relates to a semiconductor device.

As demand for high performance, high speed, and/or multifunctionality in semiconductor devices has increased, demand for an increased degree of integration of semiconductor devices has also increased. To meet the demand for a high degree of integration of semiconductor devices, semiconductor devices having a three-dimensional structure channel are currently under development.

As the degree of integration of semiconductor devices increases, it is necessary to decrease a line width and/or a pitch of patterns. However, when an interconnection area (for example, a contact area) is insufficiently secured, contact resistance may be increased.

### SUMMARY

Example embodiments provide a semiconductor device having an electrical connection structure, advantageous for high integration and having improved reliability

According to an example embodiment, a semiconductor device includes: an active pattern extending in a first direction, parallel to an upper surface of a substrate, on the substrate; a gate structure extending in a second direction, intersecting the first direction, on the active pattern; a source/drain region disposed in a region, adjacent to the gate structure, on the active pattern; an interlayer insulating layer covering the gate structure and the source/drain region; and a contact structure penetrating through the interlayer insulating layer and contacting the source/drain region. The contact structure may include a contact plug, an insulating liner surrounding a sidewall of the contact plug, and a conductive barrier layer disposed between the insulating liner and the contact plug and on a bottom surface of the contact plug. The conductive barrier layer may have a barrier extension portion extending downwardly from a lower end of the insulating liner.

According to an example embodiment, a semiconductor device includes: an active pattern extending in a first direction, parallel to an upper surface of a substrate, on the substrate; a gate structure extending in a second direction, intersecting the first direction, on the active pattern; a source/drain region disposed on a side of the gate structure, on the active pattern; an interlayer insulating layer covering the gate structure and the source/drain region; a first contact structure penetrating through the interlayer insulating layer to contact the source/drain region; and a second contact structure penetrating through the interlayer insulating layer to contact the gate structure. The first contact structure may include a first contact plug, a first insulating liner surrounding a sidewall of the first contact plug, and a first conductive barrier layer disposed between the first insulating liner and the first contact plug and on a bottom surface of the first contact plug, and the first conductive barrier layer may have a first barrier extension portion extending downwardly from a lower end of the first insulating liner to be in contact with the interlayer insulating layer. The second contact structure may include a second contact plug, a second insulating liner surrounding a sidewall of the second contact plug, and a second conductive barrier layer disposed between the second insulating liner and the second contact plug and on a bottom surface of the second contact plug, and the second conductive barrier layer may have a second barrier extension portion extending downwardly from a lower end of the second insulating liner.

According to an example embodiment, a semiconductor device includes: an active pattern extending in a first direction, parallel to an upper surface of a substrate, on the substrate; a gate structure extending in a second direction, intersecting the first direction, on the active pattern; a source/drain region disposed in a region, adjacent to the gate structure, on the active pattern; an interlayer insulating layer covering the gate structure and the source/drain region; a contact structure penetrating through the interlayer insulating layer to contact the source/drain region; a low-κ dielectric layer disposed on the interlayer insulating layer; an etch-stop layer disposed between the interlayer insulating layer and the low-κ dielectric layer; an interconnection line disposed in the low-κ dielectric layer and including a via contact contacting the contact structure; and an insulating barrier layer disposed on a sidewall of the via contact and spaced apart from an upper surface of the contact structure. The contact structure may include a contact plug, an insulating liner surrounding a sidewall of the contact plug, and a conductive barrier layer disposed between the insulating liner and the contact plug and on a bottom surface of the contact plug, and the conductive barrier layer may have a barrier extension portion extending downwardly from a lower end of the insulating liner and contacting the interlayer insulating layer. The via contact may have a contact extension portion extending downwardly from the lower end of the insulating barrier layer and contacting at least one of the etch-stop layer and the low-κ dielectric layer.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a plan view of a semiconductor device according to an example embodiment.
FIGS. 2A and 2B are cross-sectional views of the semiconductor device of FIG. 1, respectively taken along lines II-II' and II1-II1' of FIG. 1.
FIGS. 3A and 3B are cross-sectional views of the semiconductor device of FIG. 1, respectively taken along lines I2-I2' and II2-II2' of FIG. 1.
FIG. 4 is a partially enlarged view of portion "A" of the semiconductor device of FIG. 2A.
FIG. 5 is a partially enlarged view of portion "B" of the semiconductor device of FIG. 3A.
FIGS. 6 and 7 are cross-sectional views of semiconductor devices according to various embodiments.
FIGS. 8 to 12 are cross-sectional views of main processes of a method of fabricating a semiconductor device according to an example embodiment.
FIG. 13 is a plan view of a semiconductor device according to an example embodiment.
FIG. 14 illustrates cross-sectional views of the semiconductor device of FIG. 13, respectively taken along lines I-I' and II-II'.
FIG. 15 illustrates cross-sectional views of a semiconductor device according to an example embodiment.

### DETAILED DESCRIPTION

Hereinafter, example embodiments will be described with reference to the accompanying drawings.

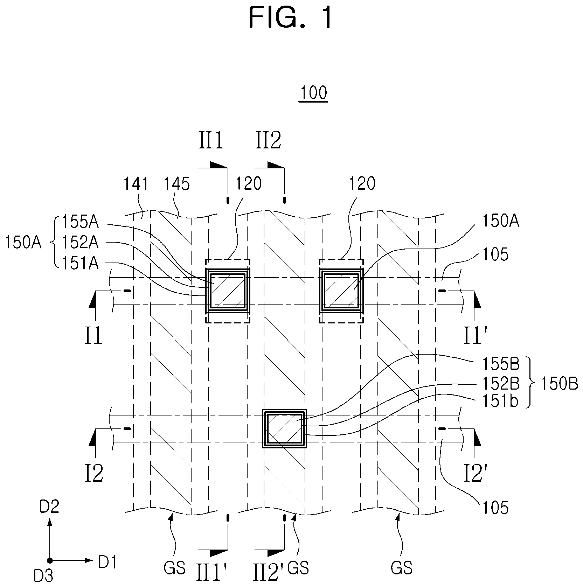

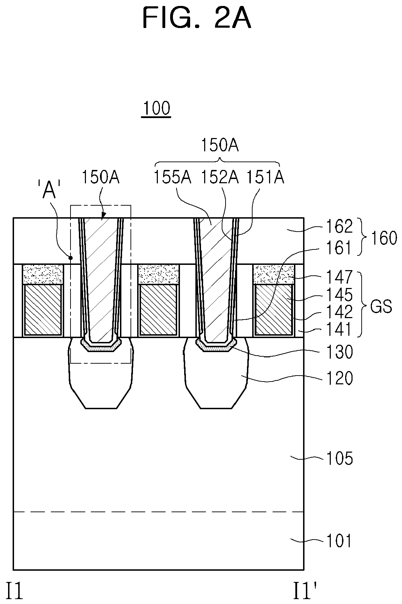

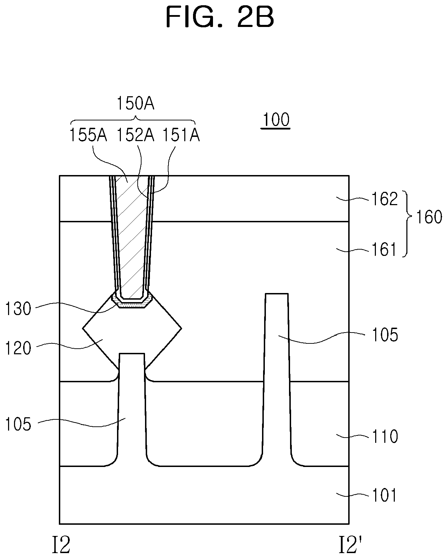

FIG. 1 is a plan view of a semiconductor device according to an example embodiment, and FIGS. 2A and 2B are cross-sectional views of the semiconductor device of FIG. 1, respectively taken along lines I1-I1', and II1-II1' of FIG. 1.

Referring to FIGS. 1 and 2 (2A and 2B), a semiconductor device 100 according to the present embodiment may include a substrate 101 and active fins/patterns 105 extending in a first direction (for example, D1) on the substrate 101, and a plurality of gate structures GS intersecting/overlapping the active patterns/fins 105 on the substrate 101 and extending in a second direction (for example, a D2 direction), perpendicular to the first direction. The first and second directions may be perpendicular to a third direction (for example, a D3 direction). The third direction may be perpendicular to a top surface of the substrate 101.

The substrate 101 may include or be formed of, for example, a semiconductor such as silicon Si or Ge, or a compound semiconductor such as SiGe, SiC, GaAs, InAs, or InP. In another embodiment, the substrate 101 may have a silicon-on-insulator (SOI) structure. The substrate 101 may include an active region such as an impurity-doped well or an impurity-doped structure. For example, the active region may have or may be an N-type well for a P-type metal-oxide-semiconductor (PMOS) transistor or a P-type well for an N-type metal-oxide-semiconductor (NMOS) transistor.

Each of the active fins 105 may have a pattern protruding from an upper surface of the substrate 101 (or the active region) in the third direction (for example, D3). The active fin 105 may be provided as a channel region of a transistor.

An isolation layer 110 may define an active fin 105. For example, the isolation layer 110 may include a silicon oxide or a silicon oxide-based insulating material. The active fin 105 may have a portion protruding from an upper portion/surface of the isolation layer 110 while penetrating through the isolation layer 110.

The semiconductor device 100 according to the present embodiment may include a gate structure GS. As illustrated in FIG. 1, the gate structure GS may have a line shape (e.g., a gate line structure) extending in the second direction (for example, D2). The gate structure GS may overlap one region of each of the active fins 105. The gate structure GS may include gate spacers 141, a gate dielectric/insulating layer 142 and a gate electrode 145 sequentially disposed between the gate spacers 141, and a gate capping layer 147 disposed on the gate electrode 145. For example, the gate dielectric/insulating layer 142 may include a silicon oxide and/or a high-κ dielectric material. A high-κ dielectric material may be a material that has a dielectric constant κ that is higher than the dielectric constant of silicon dioxide. The gate electrode 145 may include a conductive material such as doped silicon, a metal nitride (for example, TiN, TaN, or WN, or the like), or a metal (for example, W). For example, the gate spacer 141 may be formed of an insulating material such as SiO, SiN, SiON, or SiOC, and the gate capping layer 147 may be formed of an insulating material such as SiN or SiON.

The semiconductor device 100 according to the present embodiment may include the source/drain regions 120 disposed in the active fin regions 105 disposed on opposite sides of and adjacent to the gate structure GS. The source/drain region/pattern 120 may form a recess in a region of the active fin 105 and may include an epitaxial layer formed by a selective epitaxial growth (SEG) in the recess. The source/drain region/pattern 120 may include Si, SiGe, or Ge, and the source/drain region 120 may have a different material or a different shape depending on the N-type or P-type transistor. For example, in the case of a PMOS transistor, the source/drain region 120 may include silicon-germanium (SiGe) and may be doped with P-type impurities (for example, boron (B), indium (In), gallium (Ga)). A cross-section (for example, see FIG. 2B) of the source/drain region 120 may have a pentagonal shape. In the case of an NMOS transistor, the source/drain region 120 includes silicon and may be doped with N-type impurities (for example, phosphorus (P), nitrogen (N), arsenic (As), and antimony (Sb)). The cross-section of the source/drain region 120 may be a hexagonal shape or a polygonal shape having a gentle angle. As described above, the active fin 105 may constitute a transistor together with the gate structure GS and the source/drain regions 120.

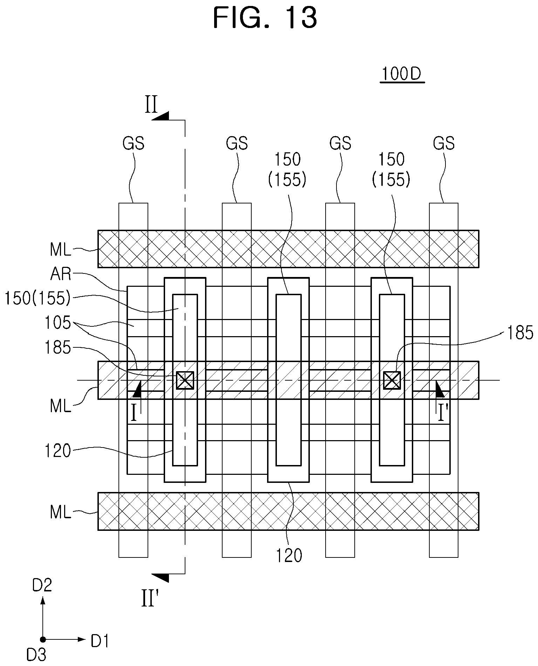

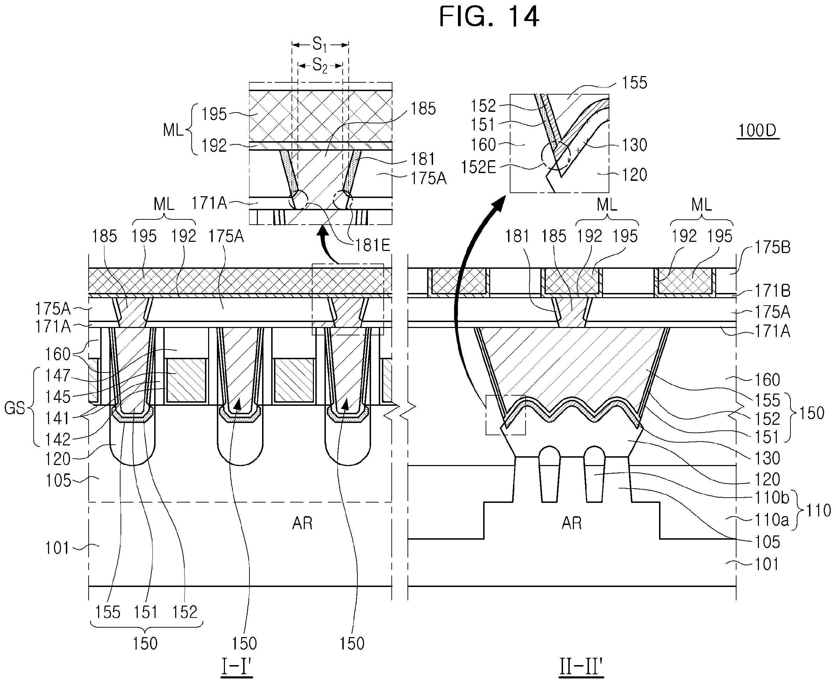

In the present embodiment, as illustrated in FIGS. 1 and 2B, the source/drain region 120 is illustrated as being formed on a single active fin 105, but example embodiments are not limited thereto and the source/drain region 120 may be formed across a plurality of active fins (see FIGS. 13 and 14).

An interlayer insulating layer 160 may be disposed on the isolation layer 110. The interlayer insulating layer 160 may include a first interlayer insulating layer 161, surrounding the gate structure GS, and a second interlayer insulating layer 162 disposed on the first interlayer insulating layer 161 to cover the gate structure GS. For example, at least one of the first and second interlayer insulating layers 161 and 162 may include or be formed of flowable oxide (FOX), Tonen SilaZen (TOSZ), undoped silica glass (USG), borosilica glass (BSG), phosphosilica glass (PSG), borophosphosilica glass (BPSG), plasma enhanced tetra ethyl ortho silicate (PETEOS), fluoride silicate glass (FSG), high density plasma (HDP) oxide, plasma enhanced oxide (PEOX), flowable CVD (FCVD) oxide, or a combination thereof. At least one of the first and second interlayer insulating layers 161 and 162 may be formed using a chemical vapor deposition (CVD) process, a flowable-CVD process, or a spin coating process.

The semiconductor device 100 according to the present embodiment may include a first contact structure 150A, electrically connected to (e.g., contacting) the source/drain region 120, and a second contact structure 150B electrically connected to (e.g., contacting) the gate electrode 145. Each of the first and second contact structures 150A and 150B may be formed to penetrate through the interlayer insulating layer 160 in the third direction (for example, D3).

As used herein, components described as being "electrically connected" are configured such that an electrical signal can be transferred from one component to the other (although such electrical signal may be attenuated in strength as it transferred and may be selectively transferred).

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element, there are no intervening elements present at the point of contact.

Referring to FIGS. 2A and 2B, the first contact structure 150A may include a first insulating liner 151A, a first conductive barrier layer 152A, and a first contact plug 155A. The first conductive barrier layer 152A may be disposed on a sidewall and a bottom surface of the first contact plug 155A, and the first insulating liner 151A may be disposed between the conductive barrier layer 152A and the interlayer insulating layer 160 to surround the sidewall of the first contact plug 155A. For example, the first conductive barrier layer 152A may be disposed between the first insulating liner 151A and the first contact plug 155A and on the bottom surface of the first contact plug 155A.

A metal silicide layer 130 may be formed in a region/portion of the source/drain region 120 where the first contact structure 150A contacts the source/drain region 120 to reduce contact resistance. The metal silicide layer 130 may be disposed below the first conductive barrier layer 152A and in a top/upper portion of the source/drain regions 120.

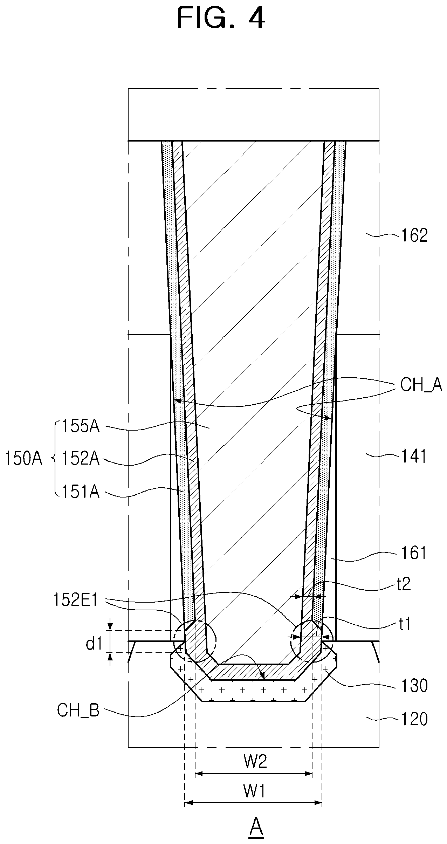

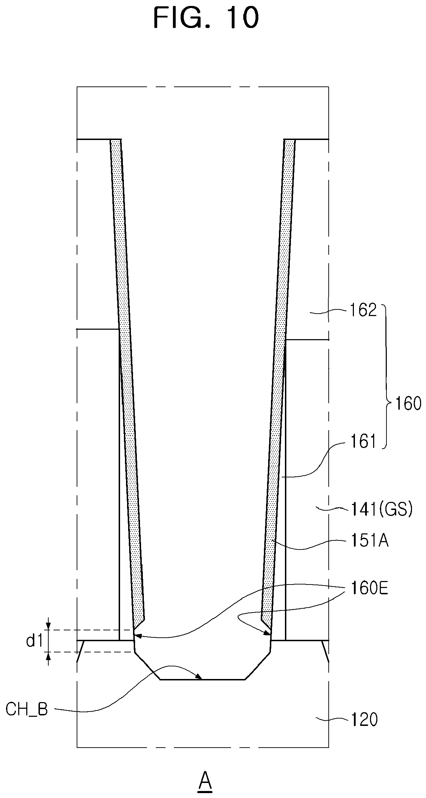

As illustrated in FIG. 4, the first insulating liner 151A employed in the present embodiment may be formed along a sidewall CH_A of a contact hole and may float (e.g., spaced apart) from a bottom surface CH_B of the contact hole. For example, a lower end or lower end portion of the first insulating liner 151A may be spaced apart from the bottom surface CH_B of the contact hole by a predetermined distance d1. As described above, the disposition of the floating first insulating liner 151A may be obtained by removing a region of an adjacent sidewall portion in a removal process of a bottom portion of the first insulating liner 151A (see FIG. 10), and the distance d1 may be controlled by adjusting such removal process conditions (for example, time).

The first conductive barrier layer 152A may have a first barrier extension portion 152E1 extending downwardly from the lower end or lower end portion of the first insulating liner 151A. Since the first barrier extension portion 152E1 extends in a horizontal direction (for example, D1 or D2) from a portion disposed on the bottom surface of the first contact plug 155A, the source/drain region 120 and a contact area may be increased. For example, the first barrier extension portion 152E1 extends in a horizontal direction and in a vertical direction, thereby increasing the contact area between the source/drain region 120 and the first conductive barrier layer 152A.

A thickness t1 of the first barrier extension portion 152E1 may be greater than a thickness t2 of a portion of the first conductive barrier layer 152A disposed on and/or horizontally overlapping the first insulating liner 151A. The thickness t1 of the first barrier extension portion 152E1 may be defined as a length in a direction in which the first barrier extension portion 152E1 extends horizontally, e.g., a horizontal thickness of the first barrier extension portion. The thickness t1 of the first barrier extension portion 152E1 may be increased by the extending portion, as compared with a thickness t2 of another portion of the first conductive barrier layer 152A. For example, the extended portion of the first barrier extension portion 152E1 is defined by a removed region of the first insulating liner 151A, and thus, may be equal to or similar to the thickness t2 of the first insulating liner 151A.

A shape of the first contact structure 150A may also be changed by the first barrier extension portion 152E1. For example, as illustrated in FIG. 4, a first width W1 of the first contact structure 150A, defined by a distance between opposite outer sides of the first barrier extension portion 152E1, may be greater than a second width W2 of the first contact structure 150A defined by a distance between opposite outer sides of the first conductive barrier layer 151A in a lower end portion of the first insulating liner 151A (e.g., in a portion horizontally overlapping the first insulating liner 151A).

Since the first insulating liner 151A is spaced apart from the bottom surface CH_B of the contact hole, the first insulating liner 151A may not cover a region, adjacent to the bottom surface CH_B, of the sidewall CH_A of the contact hole, as illustrated in FIG. 4. In the present embodiment, the uncovered sidewall region of the contact hole may be provided by the interlayer insulating layer 160 (in particular, the first interlayer insulating layer 161), so that a portion (for example, an upper region) of the first barrier extension portion 152E1 may be in contact with the interlayer insulating layer 160. Another portion (for example, a lower region) of the first barrier extension portion 152E1 may be disposed in/on the source/drain region 120 without being in contact with the interlayer insulating layer 160.

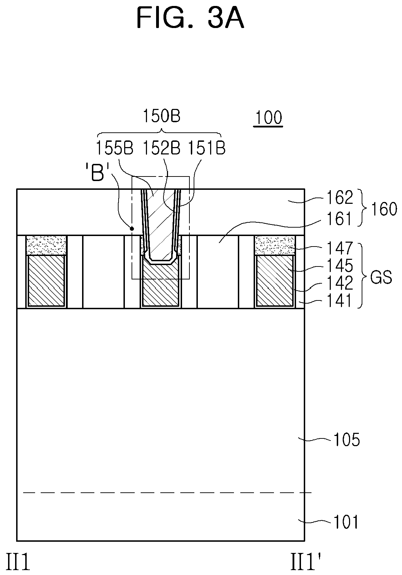

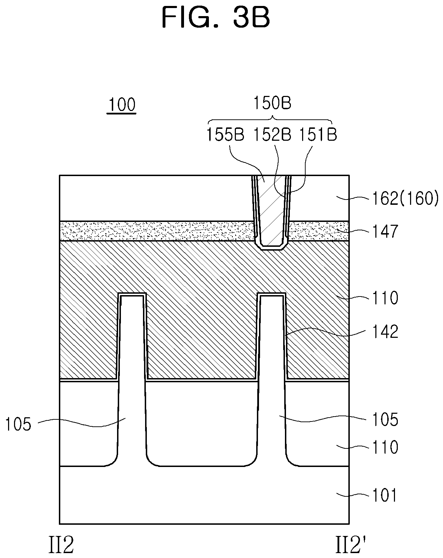

Referring to FIGS. 3A and 3B, similarly to the first contact structure 150A, the second contact structure 150B may include a second insulating liner 151B, a second conductive barrier layer 152B, and a second contact plug 155B. The second conductive barrier layer 152B may be disposed on a sidewall and a bottom surface of the second contact plug 155B, and the second insulating liner 151B may be disposed between the conductive barrier layer 152B and the interlayer insulating layer 160 to surround the sidewall of the second contact plug 155B. For example, the second conductive barrier layer 152B may be disposed between the second insulating liner 151B and the second contact plug 155B and on the bottom surface of the second contact plug 155B. For example, the second conductive barrier layer 152B may be disposed between and contact a surface of the second insulating liner 152B and a surface of the second contact plug 155B on a side surface of the contact hole.

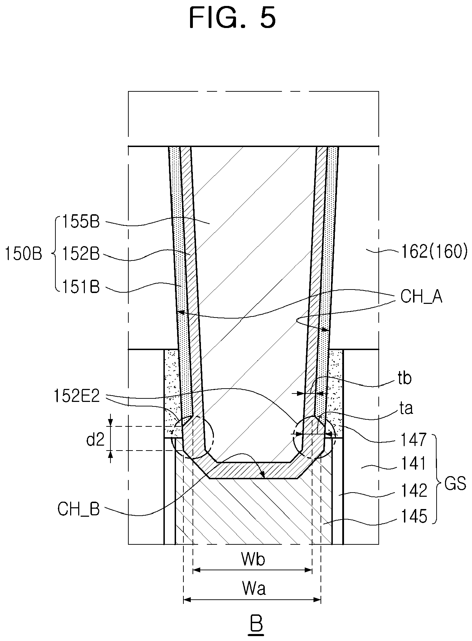

As illustrated in FIG. 5, similarly to the first insulating liner 151A, the second insulating liner 151B employed in the present embodiment may also be formed along the sidewall CH_A of the contact hole and may float (e.g., spaced apart) from the bottom surface CH_B of the contact hole. For example, a lower end or end portion of the second insulating liner 151B may be spaced apart from the bottom surface CH_B of the contact hole by a predetermined distance d2. As similarly described above with respect to the first insulating liner 151A, the disposition of the floating second insulating liner 151B may be obtained by removing a region of an adjacent sidewall portion of the second insulating liner 151B in a removal process of a bottom portion of the second insulating liner 151B (see FIG. 10). The distance d2 may be controlled by adjusting such removal process conditions (for example, time).

The second conductive barrier layer 152B may have a second barrier extension portion 152E2 extending downwardly from a lower end or end portion of the second insulating liner 151B. Since the second barrier extension portion 152E2 extends in a horizontal direction (for example, D1 or D2) from a portion disposed on a bottom surface of the second contact plug 155B, a contact area with the gate electrode 145 may be increased.

A thickness "ta" of the second barrier extension portion 152E2 may be greater than a thickness "tb" of a portion of the second conductive barrier layer 152B disposed on (e.g., horizontally overlapping) the second insulating liner 151B. The thickness "ta" of the second barrier extension portion 152E2 may be defined as an extended horizontal length. The thickness "ta" of the second barrier extension portion 152E2 may be increased by the extended portion, as compared with the thickness "tb" of another portion of the second conductive barrier layer 152B. For example, the extended portion of the second barrier extension portion 152E2 is defined by the removed region of the second insulating liner 151B, and thus may be the same as or similar to the thickness "tb" of the second insulating liner 151B.

A shape of the second contact structure 150B may also be changed by the second barrier extension portion 152E2. For example, as illustrated in FIG. 5, a first width "Wa" of the second contact structure 150A, defined by a distance between opposite outer sides of the second barrier extension portion 152E2, may be greater than a second width "Wb" of the second contact structure 150B defined by a distance between opposite outer sides of the second conductive barrier layer 151B in a lower end portion of the second insulating liner 151B, e.g., in a portion horizontally overlapping the second insulating liner 151B.

Since the second insulating liner 151B is spaced apart from the bottom surface CH_B of the contact hole, the second insulating liner 151b may not cover a region, adjacent to the bottom surface CH_B, of the sidewall CH_A of the contact hole, as illustrated in FIG. 4. In the present embodiment, the uncovered sidewall region of the contact hole may be provided by the gate capping layer 147, so that the second barrier extension portion 152E2 may be in contact with the gate capping layer 147. In some embodiments, when the second barrier extension portion 152E2 further extends in the horizontal direction, the second barrier extension portion 152E2 may be in contact with the gate spacer 141.

For example, the first and second insulating liners 151A and 151B may include or be formed of a silicon carbon nitride (SiCN), a silicon carbon oxynitride (SiCON), a silicon nitride (SiN), or a combination thereof, and the first and second conductive barrier layers 152A and 152B may include titanium (Ti), tantalum (Ta), a titanium nitride (TiN), a tantalum nitride (TaN), or a combination thereof. The metal silicide layer 130 may include or be formed of CoSi, NiSi, or TiSi. For example, the first and second contact plugs 155A and 155B may include or be formed of tungsten (W), cobalt (Co), titanium (Ti), an alloy thereof, or a combination thereof.

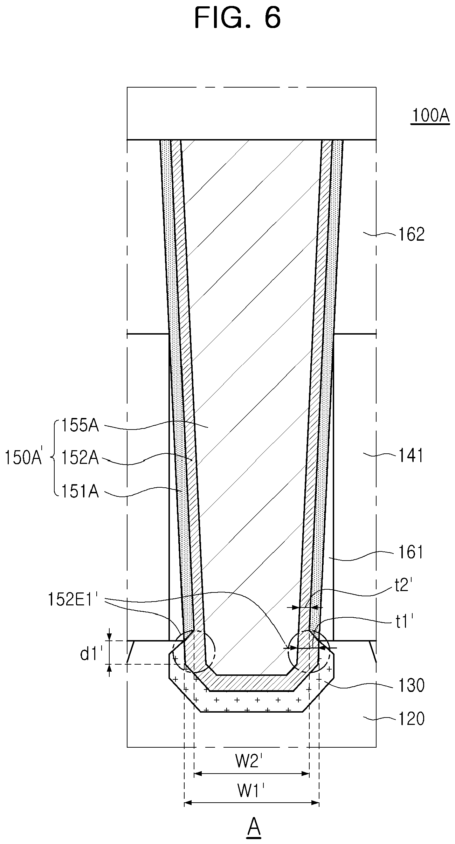

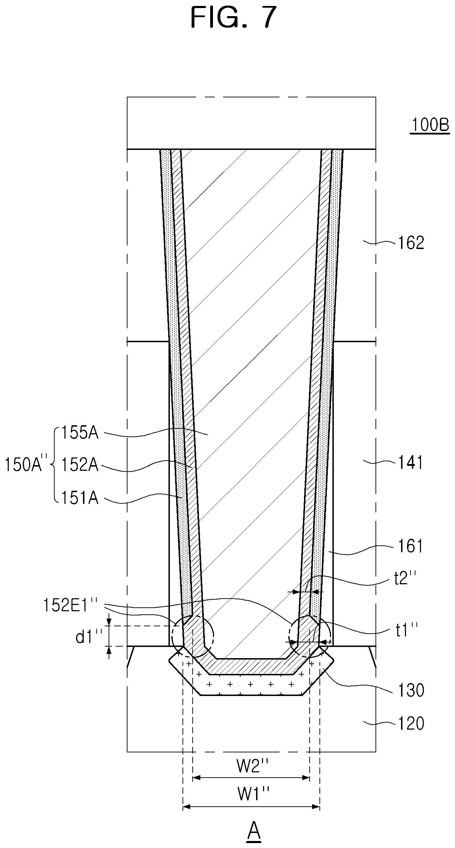

FIGS. 6 and 7 are cross-sectional views of semiconductor devices according to various embodiments, respectively. For example, FIGS. 6 and 7 illustrate cross-sections of a first contact structure and a peripheral portion thereof, and each of the cross-sections may be understood to correspond to the cross-section of FIG. 4, among the drawings of the previous embodiment.

Referring to FIG. 6, a semiconductor device 100A according to the present embodiment may be understood to be similar to the example embodiment illustrated in FIGS. 1 to 5 (in particular, FIG. 4), except that a first contact structure 150A' extends deeper in a source/drain region 120 and a first barrier extension portion 152E1' is disposed in a source/drain region 120. For example, elements of the present embodiment may be understood with reference to the descriptions of the same or similar components of the example embodiment illustrated in FIGS. 1 to 5, unless otherwise specified. For example, elements of the present embodiment may be the same as the components of the example embodiments illustrated in FIGS. 1 to 5 unless otherwise specified.

Similarly to the first contact structure 150A of the previous embodiment, the first contact structure 150A' employed in the present embodiment may include a first insulating liner 151A, a first conductive barrier layer 152A, and a first contact plug 155A. However, the first contact structure 150A' may be disposed deeper in the source/drain region 120 than the first contact structure 150A of the previous embodiment.

The first insulating liner 151A may be disposed to float (e.g., spaced apart) from a bottom surface of a contact hole, and may be spaced apart from the bottom surface of the contact hole by a predetermined distance d1'. The first conductive barrier layer 152A may have a first barrier extension portion 152E1 extending downwardly from a lower end or end portion of the first insulating liner 151A. A contact area between the first contact structure 150A and the source/drain region 120 may be increased by the first barrier extension portion 152E1, e.g., when comparing with a structure in which the first insulating liner 151A is not spaced apart from the bottom surface of the contact hole.

As in the present embodiment, when the first contact structure 150A' is formed to be relatively deep, at least a portion of a sidewall region, which is not covered with the first insulating liner 151A, may be disposed in and/or contact the source/drain region 120. In the present embodiment, an entirety of the uncovered sidewall region by the first insulating liner 151A may be disposed in the source/drain region 120, as illustrated in FIG. 6.

Unlike the previous embodiment, the first barrier extension portion 152E1' may not be in contact with an interlayer insulating layer 160 and may be in contact with the source/drain region 120 (in particular, a metal silicide layer 130).

As illustrated in FIG. 6, a thickness t1' of the first barrier extension portion 152E1' may be greater than a thickness t2' of a portion of the first conductive barrier layer 152A disposed on or horizontally overlapping the first insulating liner 151A. A first width W1' of the first contact structure 150A, defined by a distance between opposite outer sides of the first barrier extension portion 152E1' may be greater than a second width W2' of the first contact structure 150A, defined by a distance between opposite outer sides of the first conductive barrier layer 151A, in a lower end portion of the first insulating liner 151A, e.g., in a portion horizontally overlapping the first insulating liner 151A.

Alternatively, referring to FIG. 7, a semiconductor device 100B according to the present embodiment may be understood to be similar to the example embodiment illustrated in FIGS. 1 to 5 (in particular, FIG. 4), except that a depth at which a first contact structure 150A extends to a source/drain region 120 is relatively small and most of a first barrier extension portion 152E" is disposed on the source/drain region 120. Therefore, elements of the present embodiment may be understood with reference to the descriptions of the same or similar components of the example embodiment illustrated in FIGS. 1 to 5, unless otherwise specified. For example, elements of the present embodiment may be the same as the components of the example embodiments illustrated in FIGS. 1 to 5 unless otherwise specified.

Similarly to the first contact structure 150A of the previous embodiment, the first contact structure 150A" employed in the present embodiment may include a first insulating liner 151A, a first conductive barrier layer 152A, and a contact plug 155A. However, the first contact structure 150A" may be disposed to be less deep into a source/drain region 120 than the first contact structure 150A of the previous embodiment, and a distance d1" at which the first insulating liner 151A floats may be greater than the distances d1 and d1' in the previous embodiments. The first conductive barrier layer 152A may have a first barrier extension portion 152E1" extending downwardly from a lower end or end portion of the first insulating liner 151A. A contact area between the first contact structure 150A and the source/drain region 120 may be increased by the first barrier extension portion 152E1 ".

In the present embodiment, most of a sidewall region of the via hole, which is not covered with the first insulating liner 151A, may be disposed outside the source/drain region 120 and, as illustrated in FIG. 6, most of an entirety of the uncovered sidewall region of the contact hole may be provided by an interlayer insulating layer 160. Most of the first barrier extension portion 152E1" may be in contact with the interlayer insulating layer 160 (in particular, a first interlayer insulating layer 161).

As illustrated in FIG. 7, a thickness t1" of the first barrier extension portion 152E1" may be greater than a thickness t2" of a portion of the first conductive barrier layer 152A disposed on the first insulating liner 151A. In addition, a first width W1" of the first contact structure 150A", defined by a distance between opposite outer sides of the first barrier extension portion 152E1", may be greater than a second width W2" of the first contact structure 150A", defined by a distance between opposite outer sides of the first conductive barrier layer 152A, in a lower end portion of the first insulating liner 151A, e.g., in a portion horizontally overlapping the first insulating liner 151A.

As described above, the first barrier extension portions 152E1, 152E1', and 152E1" increasing a contact area may have various structures depending on a depth of the first contact structure 150A (or a depth of a contact hole) and/or a distance at which the first insulating liner 151A floats, e.g., a spaced apart distance between a bottom end of the first insulating liner 151A and the bottom surface of the contact hole. Similarly to the first contact structure 150A illustrated in FIGS. 6 and 7, the second contact structure 150B electrically connected to (e.g., contact) the gate electrode 145 may also be modified to have various shapes. For example, the same structure as the ones illustrated in FIGS. 6 and 7 may be applied to the second contact structure 150B in certain embodiments.

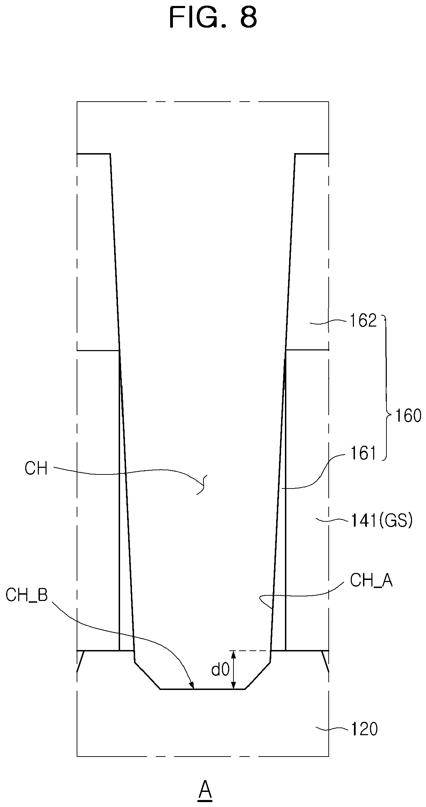

FIGS. 8 to 12 are cross-sectional views of main processes of a method of fabricating a semiconductor device according to an example embodiment.

Referring to FIG. 8, a contact hole CH may be formed in an interlayer insulating layer 160 to expose a portion of a source/drain region 120.

The contact hole CH may be formed by an etching process using a mask pattern. In some embodiments, as the degree of integration of a semiconductor device increases, a self-aligned contact (SAC) process may be used to form the contact hole CH. The contact hole CH may be formed by a self-aligned contact (SAC) process to have a structure directed to a semiconductor substrate 101 (in particular, a source/drain region 120) using a sidewall of an adjacent gate structure GS.

The contact hole CH may have a bottom surface CH_B and a sidewall CH_A exposing a portion of the source/drain region 120. The sidewall CH_A of the contact hole CH may be provided by the interlayer insulating layer 160. For example, the interlayer insulating layer 160 may form the sidewall CH_A of the contact hole CH. In some embodiments (for example, a SAC process), the sidewall CH_A of the contact hole CH may be partially provided by the gate structure GS. As illustrated in FIG. 8, a portion of a center of the sidewall CH_A of the contact hole CH may be provided by the gate spacer 141.

The contact hole CH may be formed to have various depths. For example, a depth d0 of the contact hole CH, recessed into the source/drain region 120, may be variously changed, e.g., may have various values. As described in the previous embodiments, a location and a shape of the barrier extension portion 152E1 may vary depending on the recessed depth d0. In some embodiments, an ion implantation process may be additionally performed on the recessed region of the source/drain region 120 after the contact hole CH is formed.

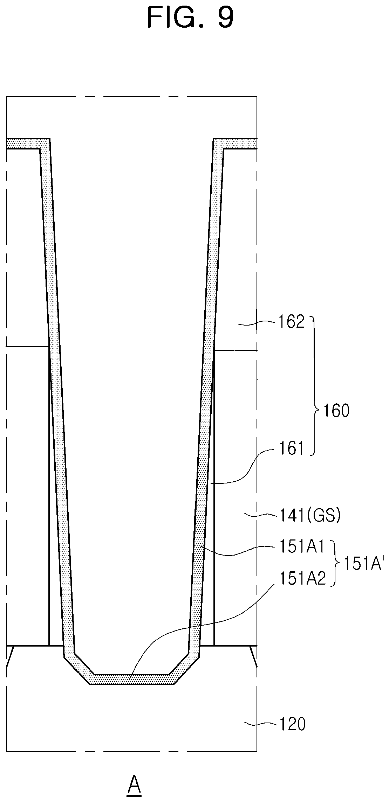

Referring to FIG. 9, an insulating liner material layer 151A' may be formed on an internal surface of the contact hole CH.

After the contact hole CH is formed, the insulating liner material layer 151A' may be conformally formed on the sidewall CH_A and the bottom surface CH_B of the contact hole. The present process may be performed by an atomic layer deposition (ALD), a chemical vapor deposition (CVD), or a physical vapor deposition (PVD) process. The insulating liner material layer 151A' may also be formed on an upper surface of the interlayer insulating layer 160. For example, the insulating liner material layer 151A' may include or be formed of a silicon carbon nitride (SiCN), a silicon carbon oxynitride (SiCON), a silicon nitride (SiN), or a combination thereof.

Referring to FIG. 10, a bottom portion 151A2 of the insulating liner material layer 151A' may be removed to expose a contact region with the source/drain region 120, and a sidewall portion 151A1 of the insulating liner material layer 151A' may remain.

Such a selective removal process may be performed by an anisotropic etching process. For example, the bottom portion 151A2 of the insulating liner material layer 151A' may be removed by performing an etching process after performing a surface treatment using oxygen and/or hydrogen plasma. Accordingly, the bottom surface CH_B of the contact hole, for example, the contact region of the source/drain region 120 may be exposed again.

Spatially relative terms, such as "beneath," "below," "lower," "above," "upper," "lateral," "vertical," 'downward," "upward," and the like, may be used herein for ease of description to describe positional relationships. It will be understood that the spatially relative terms encompass different orientations of the device in addition to the orientation depicted in the figures.

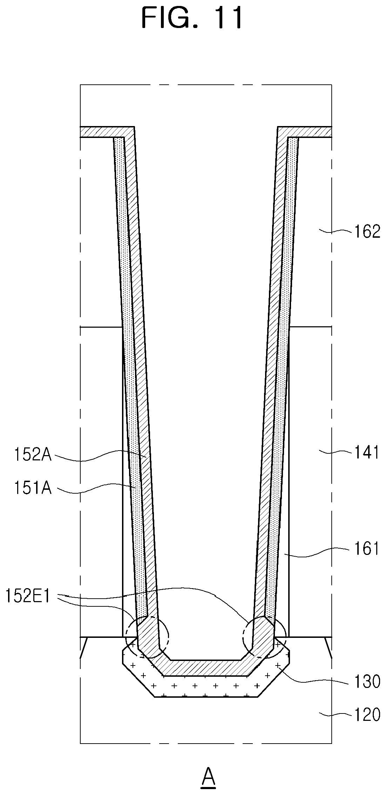

In such a selective removal process, a portion of the sidewall portion 151A1 adjacent to the bottom portion 151A2 may also be removed by a predetermined length d1. As described above, a lower region of the sidewall portion 151A1 may be intentionally removed to secure a space for the first barrier extension portion (152E1 of FIG. 11). The remaining sidewall portion 151A1 may serve as the first insulating liner 151A of the final semiconductor device 100. In the present process, a portion of the insulating liner material layer 151A' disposed on a top surface of the interlayer insulating layer 160 may be removed together (see FIG. 10).

Referring to FIG. 11, a metal silicide layer 130 may be formed in an exposed portion of the source/drain region 120, and a first conductive barrier layer 152A may be formed on the internal surface of the contact hole CH.

In the present process, the metal silicide layer may be formed by various processes. For example, a metal layer may be formed on the exposed portion of the source/drain region 120, and a first conductive barrier layer 152A may then be conformally formed on a surface of the metal layer and the internal surface of the contact hole CH. Then, a metal silicide layer 130 may be formed from the metal layer using an annealing process. For example, the metal layer may include or be formed of titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd), or a combination thereof. The conductive barrier layer 152A may be formed using a physical vapor deposition (PVD), chemical vapor deposition (CVD), or atomic layer deposition (ALD) process. The first conductive barrier layer 152A may be formed of a conductive metal nitride. For example, the conductive barrier layer 152A may include or be formed of TiN, TaN, AlN, WN, or a combination thereof.

The first conductive barrier layer 152A may have a first barrier extension portion 152E1 extending downwardly from a lower end or end portion of the first insulating liner 151A. In the previous process, a portion of the sidewall portion 151A1 of the insulating liner material layer 151 A' is removed together with the bottom portion 151A2 of the insulating liner material layer 151 A', so that the first barrier extension portion 152E1 may be provided by filling the space with the first conductive barrier layer 152A. Since the first barrier extension portion 152E1 extends in a horizontal direction from a portion disposed on a bottom surface of the first contact plug 155A, the source/drain region 120 exposed through the contact hole and the contact area between the source/drain region 120 and the first conductive barrier layer 152A may be increased.

Since the first insulating liner 151A is spaced apart from the bottom surface CH_B of the contact hole, in the present embodiment, a portion (for example, an upper region) of the first barrier extension portion 152E1 may be in contact with the interlayer insulating layer 160, in particular, the first interlayer insulating layer 161.

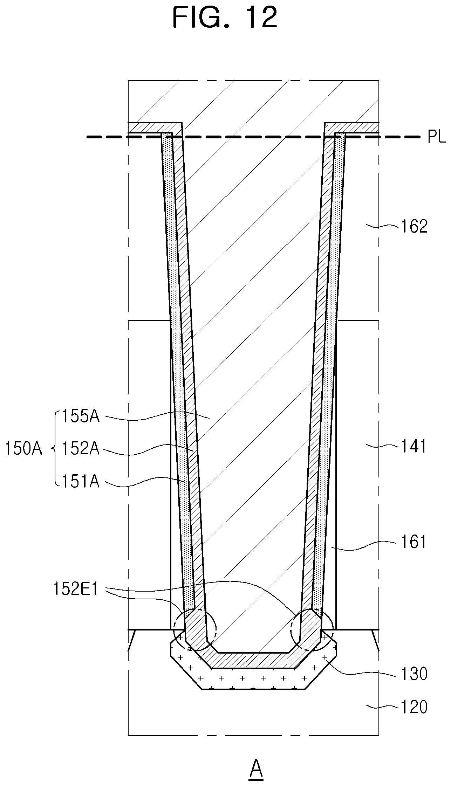

Referring to FIG. 12, a contact plug 155A may fill the remaining region of the contact hole CH, and the contact plug 155A and the conductive barrier 152A in an unnecessary region may be removed using a planarization process.

The first contact plug 155A may be formed to cover the conductive barrier layer 152A on the interlayer insulating layer 160 while filling an internal region of the contact hole CH. For example, the first contact plug 155A may include or be formed of tungsten (W), cobalt (Co), titanium (Ti), an alloy thereof, or a combination thereof. Unnecessary portions of the first conductive barrier layer 152A and the first contact plug 155A, disposed on the interlayer insulating layer 160, may be removed such that an upper surface of the interlayer insulating layer 160 is exposed and the first conductive barrier layer 152A and the first contact plug 155A remain only in the internal region of the contact hole CH. Such a removal process may be performed through a planarization process such as a chemical mechanical polishing (CMP) process up to, for example, a predetermined level PL.

FIG. 13 is a plan view of a semiconductor device according to an example embodiment, and FIG. 14 illustrates cross-sectional views of the semiconductor device of FIG. 13, respectively taken along lines I-I' and II-II' of FIG. 13.

Referring to FIGS. 13 and 14, a semiconductor device 100D according to the present embodiment may include an active region AR disposed on a substrate 101, a plurality of active fins 105 extending in a first direction (for example, D1) on the active region AR, and a plurality of gate structures GS intersecting/overlapping the plurality of active fins 105 and extending in a second direction (for example, D2), perpendicular to the first direction, on the substrate 101.

The substrate 101 may include or be formed of, for example, a semiconductor such as Si or Ge, or a compound semiconductor such as SiGe, SiC, GaAs, InAs, or InP. The active region AR may be a conductive region such as an impurity-doped well or an impurity-doped structure. For example, the active region AR may have an N-type well for a PMOS transistor or a P-type well for an NMOS transistor.

Each of the plurality of active fins 105 may have a structure protruding upwardly (for example, in a direction D3) from an upper surface of the active region AR. As illustrated in FIG. 13, the plurality of active fins 105 may be arranged side by side in the second direction in the active region AR. The active fins 105 may be provided as a channel region of a transistor. In the present embodiment, three active fins 105 are provided, but the number of the active fins 105 is not limited thereto.

An isolation layer 110 may define an active region AR and active fins 105. The isolation layer 110 may include or be formed of a silicon oxide or a silicon oxide-based insulating material. The isolation layer 110 may include a first isolation region 110a, defining the active region AR, and a second isolation region 110b defining the active fin 105. The first isolation region 110a may have a bottom surface, deeper than the second isolation region 110b. For example, the first isolation region 110a may be a deep trench isolation (DTI) region, and the second isolation region 110b may be a shallow trench isolation (STI) region. The second isolation region 110b may be disposed on the active region AR. As described above, a portion of the active fins 105 may protrude upwardly from a top surface of the second isolation region 110b while the active fins 105 penetrate through the second isolation region 110b.

Similarly to the previous embodiment, the semiconductor device 100D according to the present embodiment may include a gate structure GS. As illustrated in FIG. 13, the gate structure GS may have a line shape extending in the second direction (for example, D2). The gate structure GS may vertically overlap one region of each of the active fins 105. The gate structure GS may include gate spacers 141, a gate dielectric/insulating layer 142 and a gate electrode 145 sequentially disposed between the gate spacers 141, and a gate capping layer 147 disposed on the gate electrode 145.

The semiconductor device 100D according to the present embodiment may include a source/drain region 120 formed in a portion of the active fins 105 disposed on opposite sides of the gate structure GS.

In the present embodiment, in the source/drain region 120, a recess may be formed in a portion of the active fins 105, and an epitaxial layer may be selectively grown/regrown in the recess. The source/drain region 120 may include Si, SiGe, or Ge and, the source/drain region 120 may have a different material and/or a different shape depending on an N-type or P-type transistor.

The semiconductor device 100D according to the present embodiment may include an interlayer insulating layer 160 disposed on the isolation layer 110. The interlayer insulating layer 160 may include a first interlayer insulating layer 161, surrounding the gate structure GS, and a second interlayer insulating layer 162 disposed on the first interlayer insulating layer 161 to cover the gate structure GS.

The contact structure 150 employed in the present embodiment may be formed through the interlayer insulating layer 160 and may be electrically connected to each of the source/drain regions 120. Similarly to the previous embodiment, the contact structure 150 may include an insulating liner 151, a conductive barrier layer 152, and a contact plug 155. The conductive barrier layer 152 may be disposed on a sidewall and a bottom surface of the contact plug 155, and the insulating liner 151 may be disposed between the conductive barrier layer 152 and the interlayer insulating layer 160 to surround the sidewall of the contact plug 155. The metal silicide layer 130 may be disposed on a bottom surface the conductive barrier layer 152 and in the source/drain region 120.

As illustrated in FIG. 14, the insulating liner 151 employed in the present embodiment may float (e.g., spaced apart) from a bottom surface of a contact hole, and the conductive barrier layer 152 may have a barrier extension portion 152E extending downwardly from a lower end or end portion of the insulating liner 151. The barrier extension portion 152E may be similarly identified in a D1-D3 cross-section as well as a D2-D3 cross-section. For example, the barrier extension portion 152E may have a substantial rotational symmetry shape with respect to a rotational axis extending in a vertical direction.

Terms such as "same," "equal," "planar," "symmetry," or "coplanar," as used herein encompass identicality or near identicality including variations that may occur, for example, due to manufacturing processes. The term "substantially" may be used herein to emphasize this meaning, unless the context or other statements indicate otherwise.

As described above, the source/drain region 120 and the contact area may be increased by the barrier extension portion 152E.

In addition, a sidewall region which is not covered with the insulating liner 151 by the floating region may be provided by the interlayer insulating layer 160, and the barrier extension portion 152E may be in contact with the interlayer insulating layer 160.

The semiconductor device 100D according to the present embodiment may further include an interconnection structure electrically connected to the contact structures 150. The interconnection structure employed in the present embodiment may include via contacts 185, respectively connected to (e.g., contact) the contact structures 150, and interconnection lines ML electrically connected to the via contacts 185. Referring to FIG. 13, three interconnection lines ML according to the present embodiment may each extend in a first direction (for example, D1) and may be arranged (e.g., spaced apart) in a second direction (for example, D2). An example of the interconnection structure employed in the present embodiment is a structure formed by a single damascene process, but is not limited thereto.

The interconnection structure may include a first etch-stop layer 171A, a first low-κ dielectric layer 175A, a second etch-stop layer 171B, and a second low-κ dielectric layer 175B sequentially formed on the interlayer insulating layer 160.

The first etch-stop layer 171A may be used as an etch-stop element for forming the via contact 185, and the second etch-stop layer 171B may be used as an etch-stop element for forming the interconnection line ML. In some embodiments, the first etch-stop layer 171A and/or the second etch-stop layer 171B may be formed of a compound containing aluminum elements. For example, the first and second etch-stop layers 171A and 171B may include or be formed of aluminum nitride (AlN), aluminum oxynitride (AlON), aluminum oxide (AlO), or aluminum oxide carbide (AlOC).

The first and second low-κ dielectric layers 175A and 175B may include or be formed of a material having a low dielectric constant (for example, 3.3 or less). In some embodiments, the first and second low-κ dielectric layers 175A and 175B may include or be formed of the same as or a similar material to the interlayer insulating layer 160. For example, the first and second low-κ dielectric layers 175A and 175B may include or be formed of a fluorine-doped silicon oxide such as SiOF, a carbon-doped silicon oxide such as SiOCH, a porous silicon oxide, an inorganic polymer such as hydrogen silsesquioxane (HSSQ) or methyl silsesquioxane (MSSQ), or a spin-on organic polymer. For example, the first and second low-κ dielectric layers 175A and 175B may be formed using a chemical vapor deposition (CVD) process, a flowable-CVD process, or a spin coating process.

The via contact 185 may have a contact extension portion 181E extending downwardly from a lower end or end portion of an insulating barrier layer 181. The insulating barrier layer 181 may also float (e.g., spaced apart) from the bottom surface. The contact extension portion 181E may be in contact with a sidewall region exposed by the floating, for example, at least one of the first etch-stop layer 171A and the first low-κ dielectric layer 175A. In the present embodiment, the contact extension portion 181E may be in contact with the first etch-stop layer 171A.

In the present embodiment, a first width S1 of the via contact 185, defined by a distance between opposite outer sides of the contact extension portion 181E, may be greater than a second width S2 of the via contact 185 in a lower end portion of the insulating barrier layer 181, e.g., in a portion horizontally overlapping the insulating barrier layer 181. A contact area between the via contact 185 and the contact structure 150 may be increased by the contact extension portion 181E as similarly described in the previous embodiments.

Each of the interconnection lines ML may include or be formed of a metal line 195, disposed on the via contact 185 in the second low-κ dielectric layer 175B, and a conductive barrier layer 192 disposed on a side surface and a lower surface of the metal line 195. For example, at least one of the via contact 185 and the metal line195 may include or be formed of Cu, Co, Mo, Ru, or W. For example, the conductive barrier layer 192 may include or be formed of Ta, TaN, Mn, MnN, WN, Ti, or TiN.

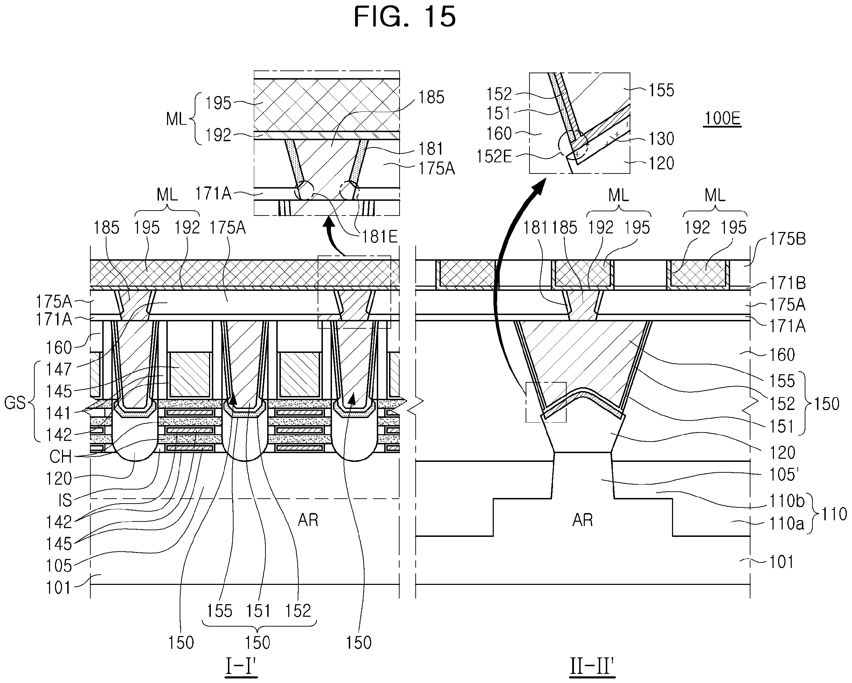

FIG. 15 illustrates cross-sectional views of a semiconductor device according to an example embodiment.

Referring to FIG. 15, a semiconductor device 100E may be understood to be similar to the semiconductor device 100D according to the example embodiment illustrated in FIGS. 13 and 14, except that the semiconductor device 100E is implemented as a multi-channel structure using a plurality of nanosheets and a single active pattern/fin 105', rather than three active fins 105, is employed. Therefore, elements of the present embodiment may be understood with reference to the descriptions of the same or similar components of the example embodiment illustrated in FIGS. 13 to 14, unless otherwise specified. For example, elements of the present embodiment may be the same as the components of the example embodiments illustrated in FIGS. 13 to 14 unless otherwise specified.

As illustrated in FIG. 15, the multi-channel structure may include a plurality of channel layers CH, disposed to be spaced apart from each other on an active region AR in a direction (for example, D3), perpendicular to an upper surface of a substrate 101, and each having a nanosheet structure, and a gate electrode 145 surrounding the plurality of channel layers CH and extending in a second direction (for example, D2), perpendicular to the first direction (for example, D1). As described above, the gate electrode 145 employed in the present embodiment may be formed to be interposed between the plurality of channel layers CH as well as between gate spacers 141.

The semiconductor device 100E may include a source/drain region 120 disposed in the active region AR disposed on opposite sides adjacent to the gate electrode 145 and electrically connected to the plurality of channel layers CH. In the present embodiment, the source/drain regions 120 may be disposed in the active region AR disposed on the opposite sides adjacent to the gate electrode 145, and may be electrically connected to opposite sides of the plurality of channel layers CH in the first direction (for example, D1), respectively. In the present embodiment, three channel layers CH are provided, but the number of channel layers CH is not limited thereto. The channel layers CH may include or may be semiconductor patterns. For example, the semiconductor patterns may include or be formed of at least one of silicon (Si), silicon-germanium (SiGe), and germanium (Ge).

The source/drain region 120 may include an epitaxial layer formed using the plurality of channel layers CH and the active region AR as seeds. The source/drain region 120 may include at least one of silicon-germanium (SiGe), silicon (Si), and silicon carbide (SiC).

The semiconductor device 100E may include internal spacers IS provided between each of the source/drain regions 120 and the gate electrode 145. The internal spacers IS may be provided on one side of the gate electrode 145. The internal spacers IS and the channel layers CH may be alternately disposed in a direction (for example, D3), perpendicular to an upper surface of the substrate 101. Each of the source/drain regions 120 may be in contact with the channel layer CH and may be spaced apart from the gate electrode 145 with the internal spacers IS interposed therebetween. The gate dielectric/insulating layer 142 may be interposed between the gate electrode 145 and each of the channel layers CH, and may extend between the gate electrode 145 and each of the inner spacers IS.

As illustrated in FIG. 15, the insulating liner 151 may float (spaced apart) upwardly from a bottom surface of the contact structure 150, and the conductive barrier layer 152 may have a barrier extension portion 152E extending downwardly from a lower end or a lower end portion of the insulating liner 151. The barrier extension portion 152E may increase a contact area with the source/drain region 120.

Similarly, the insulating barrier layer 181 may also float (spaced apart) upwardly from a bottom surface of a via contact 185, and the via contact 185 may have a contact extension portion 181E extending downwardly from a lower end or end portion of the insulating barrier layer 181. The contact extension portion 181E may increase a contact area between the via contact 185 and the contact structure 150.

As described above, when a bottom portion of an insulating liner is removed, a portion of the insulating liner disposed in a lower end region of a sidewall of a contact hole may be removed together. Thus, a conductive barrier layer formed in a subsequent process may form/have a portion extending to a lower end or end portion of the insulating liner (also referred to as an "extension portion" or an "anchor") to secure a relatively large contact area even under scaling-down conditions.

Even though different figures show variations of example embodiments and different embodiments disclose different features from each other, these figures and embodiments are not necessarily intended to be mutually exclusive from each other. Rather, as recognized from the context of the detailed description above, certain features depicted in different figures and/or described above in different embodiments can be combined with other features from other figures/embodiments to result in additional various embodiments, when taking the figures and related descriptions of embodiments as a whole into consideration. For example, components and/or features of different embodiments described above can be interchangeably combined with components and/or features of other embodiments unless the context indicates otherwise.

While example embodiments have been shown and described above, it will be apparent to those skilled in the art that modifications and variations could be made without departing from the scope of the present inventive concept as defined by the appended claims.

## Claims

1. A semiconductor device comprising:
an active pattern extending in a first direction, parallel to an upper surface of a substrate, on the substrate;
a gate structure extending in a second direction, intersecting the first direction, on the active pattern;
a source/drain region disposed in a region, adjacent to the gate structure, on the active pattern;
an interlayer insulating layer covering the gate structure and the source/drain region; and
a contact structure penetrating through the interlayer insulating layer and contacting the source/drain region,
wherein the contact structure includes a contact plug, an insulating liner surrounding a sidewall of the contact plug, and a conductive barrier layer disposed between the insulating liner and the contact plug and on a bottom surface of the contact plug, and
the conductive barrier layer has a barrier extension portion extending downwardly from a lower end of the insulating liner.

2. The semiconductor device of claim 1, wherein the barrier extension portion is in contact with the interlayer insulating layer.

3. The semiconductor device of claim 1 or claim 2, wherein a first width of the contact structure, defined by a distance between opposite outer sides of the barrier extension portion, is greater than a second width of the contact structure defined by a distance between opposite outer sides of a portion of the conductive barrier layer horizontally overlapping the insulating liner.

4. The semiconductor device of any preceding claim, wherein the barrier extension portion has a thickness greater than a thickness of a portion of the conductive barrier layer horizontally overlapping the insulating liner.

5. The semiconductor device of any preceding claim, wherein the source/drain region includes a metal silicide layer in contact with the conductive barrier layer.

6. The semiconductor device of any preceding claim, comprising:
a dielectric layer disposed on the interlayer insulating layer;
an etch-stop layer disposed between the interlayer insulating layer and the dielectric layer;
a via contact disposed in the dielectric layer and electrically connected to the contact structure; and
an insulating barrier disposed on a sidewall of the via contact and spaced apart from an upper surface of the contact structure,
wherein the via contact has a contact extension portion extending downwardly from a lower end of the insulating barrier.

7. The semiconductor device of claim 6, wherein the contact extension portion is in contact with at least one of the etch-stop layer and the dielectric layer.

8. The semiconductor device of claim 6 or claim 7, wherein a first width of the via contact, defined by a distance between opposite outer sides of the contact extension portion, is greater than a second width of the via contact between opposite outer sides of the via contact in a portion horizontally overlapping the insulating barrier.

9. The semiconductor device of any preceding claim, wherein the insulating liner includes a silicon carbon nitride, a silicon carbon oxynitride, a silicon nitride, or a combination thereof.

10. The semiconductor device of any preceding claim, wherein the conductive barrier layer includes titanium, tantalum, a titanium nitride, a tantalum nitride, or a combination thereof.

11. The semiconductor device of any preceding claim, wherein the active pattern includes a plurality of active fins respectively extending in the first direction and arranged in the second direction, and the source/drain region are disposed across the plurality of active fins.

12. The semiconductor device of any preceding claim, further comprising:
a plurality of channel layers disposed to be spaced apart from each other in a direction, perpendicular to the substrate, on the active pattern,
wherein the source/drain region is electrically connected to each of the plurality of channel layers, and
the gate structure includes a gate electrode surrounding each of the plurality of channel layers and extending in the second direction, and a gate insulating layer disposed between each of the plurality of channel layers and the gate electrode and between the active pattern and the gate electrode.

13. The semiconductor device of any preceding claim, further comprising an additional contact structure penetrating through the interlayer insulating layer to contact the gate structure,
the additional contact structure includes a second contact plug, a second insulating liner surrounding a sidewall of the second contact plug, and a second conductive barrier layer disposed between the second insulating liner and the second contact plug and on a bottom surface of the second contact plug, and the second conductive barrier layer has a second barrier extension portion extending downwardly from a lower end of the second insulating liner.

14. The semiconductor device of claim 13, wherein the gate structure includes a gate electrode extending in the second direction to vertically overlap the active pattern, a gate insulating layer disposed between the gate electrode and the active pattern, and a gate capping layer disposed on the gate electrode.

15. The semiconductor device of claim 14, wherein the second barrier extension portion of the second conductive barrier layer is in contact with the gate capping layer.
